(19) Europäisches Patentamt
European Patent Office
Office européen des brevets

(11) **EP 3 599 469 B1**

(12) **FASCICULE DE BREVET EUROPEEN**

(45) Date de publication et mention
de la délivrance du brevet:
**25.11.2020 Bulletin 2020/48**

(51) Int Cl.:
***G01P 15/12*** *(2006.01)*     ***B81B 5/00*** *(2006.01)*
***G01P 15/08*** *(2006.01)*     ***B81B 3/00*** *(2006.01)*

(21) Numéro de dépôt: **19187060.9**

(22) Date de dépôt: **18.07.2019**

(54) **ACCELEROMETRE A DETECTION PAR JAUGE DE CONTRAINTES A PRECISION AMELIOREE**

BESCHLEUNIGUNGSSENSOR MIT DEHNUNGSMESSSTREIFEN MIT VERBESSERTER PRÄZISION

ACCELEROMETER WITH DETECTION BY STRAIN GAUGE WITH IMPROVED PRECISION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.07.2018 FR 1856789**

(43) Date de publication de la demande:
**29.01.2020 Bulletin 2020/05**

(73) Titulaire: **Commissariat à l'Energie Atomique et aux Energies Alternatives
75015 Paris (FR)**

(72) Inventeur: **JOET, Loïc
38054 GRENOBLE Cedex 9 (FR)**

(74) Mandataire: **Marks & Clerk France
Immeuble "Visium"
22, avenue Aristide Briand
94117 Arcueil Cedex (FR)**

(56) Documents cités:
**FR-A1- 2 951 826    US-A1- 2015 013 456**

• **JOS E A PLAZA ET AL: "Piezoresistive Accelerometers for MCM Package", JOURNAL OF MICROELECTROMECHANICAL SYSTEMS, IEEE SERVICE CENTER, US, vol. 11, no. 6, 1 décembre 2002 (2002-12-01), XP011064822, ISSN: 1057-7157**

## Description

DOMAINE TECHNIQUE DE L'INVENTION

L'invention se situe dans le domaine des accéléromètres, plus précisément des accéléromètres NEMS ou MEMS, c'est à dire réalisés par micro-usinage dans une plaque de matériau monolithique, tel du Silicium, selon des technologies de fabrication collective semblables à celles qui sont utilisées dans la fabrication des circuits intégrés électroniques.

ETAT DE LA TECHNIQUE

De tels accéléromètres ont des applications multiples, notamment dans les domaines où on cherche à obtenir à la fois un encombrement minimal et un faible coût de production. Un domaine d'application privilégié est le domaine de la navigation automobile ou aérienne, dans lesquels ces accéléromètres permettent de déterminer, par intégration des signaux qu'ils fournissent, une trajectoire.

On attend d'un accéléromètre un certain nombre de caractéristiques, et principalement un faible encombrement, une bonne sensibilité à une accélération dans un axe bien identifié qu'on peut aussi appeler « axe sensible », une sensibilité aussi faible que possible selon les autres axes, une bonne précision de mesure, une bonne résistance mécanique, ainsi qu'un faible coût.

Les technologies de fabrication utilisées dans la microélectronique se prêtent particulièrement à l'obtention d'un faible coût de fabrication et le coût est alors directement lié à la taille du composant micro-usiné.

Selon l'application envisagée pour l'accéléromètre, on essayera d'optimiser les différentes caractéristiques ci-dessus et on fera les compromis nécessaires, par exemple un compromis entre une petite taille et une bonne sensibilité.

Un accéléromètre NEMS ou MEMS comprend en général une masse mobile (ou masse d'épreuve, "proof mass" en anglais), reliée au substrat dans laquelle elle a été usinée par une liaison élastique. La masse a pour fonction de transformer une accélération en force (ou en effort). Plusieurs transductions du mouvement de la masse vers le domaine électrique sont possibles, les plus répandues étant la détection capacitive et la détection par jauge de contrainte.

Dans ce dernier cas, au moins une jauge est fixée entre la masse et le substrat, directement ou indirectement, et subit les efforts liés au déplacement de la masse sismique lors d'une accélération.

Il peut s'agir d'une ou de plusieurs jauges de contrainte.

Les efforts sont transmis à la jauge directement ou indirectement, par exemple via une amplification mécanique par bras de levier. Avantageusement, bras de levier et masse ne peuvent faire qu'un si la masse est maintenue en rotation par une charnière. En d'autres termes, la masse peut avoir également la fonction d'amplification mécanique.

Le bras de levier permet de transmettre la force de la masse à la jauge tout en ajoutant un gain entre la force récoltée par la masse et la force appliquée à la jauge, afin d'accroitre la sensibilité.

L'axe de l'accélération, ou « axe sensible » est soit dans le plan du substrat, soit en dehors du plan du substrat (« hors plan »), comme décrit dans la demande de brevet EP2211185.

Dans le cas du hors-plan, le bras de levier peut permettre avantageusement de transformer un mouvement hors-plan en un mouvement dans le plan.

Ainsi, en fonction de la configuration de l'accéléromètre, on peut choisir de réaliser des mesures dans l'un des trois axes.

Enfin, un bras de levier, avec l'utilisation d'au moins deux jauges, permet une lecture différentielle grâce à une position astucieuse des jauges par rapport à l'axe de rotation du bras de levier.

Un exemple d'accéléromètre à déplacement dans le plan est décrit dans la demande de brevet FR2951826, qui décrit un dispositif à détection piézorésistive dans le plan. Il s'agit plus précisément d'un accéléromètre de type MEMS et/ou NEMS destiné à mesurer des déplacements orientés selon un axe situé dans le plan.

L'accéléromètre comporte une masse sismique apte à se déplacer selon l'axe de l'accélération. Elle est suspendue par au moins une poutre. La poutre forme une liaison pivot d'axe orthogonal au plan du dispositif, la masse est donc apte à se déplacer dans le plan autour de cet axe pivot.

L'accéléromètre comprend en outre au moins une jauge piézorésistive. La ou les jauge(s) présente(nt) une épaisseur réduite par rapport à celle de la masse sismique. La réduction de la section de jauge permet d'obtenir une contrainte plus forte au cœur d'une jauge, à effort constant. L'axe perpendiculaire à l'axe de pivot et passant par le centre de gravité de la masse sismique est perpendiculaire à l'axe de l'accélération à mesurer et l'axe de la jauge est perpendiculaire à l'axe reliant l'axe de pivot et le centre de gravité de la masse sismique.

Ainsi, la masse permet aussi une amplification mécanique en formant un bras de levier en rotation autour de la liaison pivot, la distance entre la liaison pivot et la jauge étant inférieure à la distance entre la liaison pivot et le centre de gravité de la masse (en inversant, une atténuation pourrait être obtenue au profit d'une raideur, et donc d'une fréquence de résonance, plus haute).

La Figure 1 illustre l'accéléromètre selon la demande de brevet FR2951826 qui comprend une masse sismique 2 maintenue à un substrat 7 (non représenté sur cette figure, mais représenté sur une autre figure de ladite demande de brevet) par deux poutres 4.1 et 4.2.

Les poutres sont fixées au substrat chacune par une extrémité en deux point distincts via un plot d'ancrage 6 et à la masse sismique 2 par une autre extrémité.

Sur le plan Oxy, les poutres présentent une longueur définissant leur direction longitudinale et une largeur. Elles présentent en outre une épaisseur selon l'axe Oz. L'intersection des poutres, et plus précisément d'axes s'étendant selon la direction longitudinale de chaque poutre et situés sur la demi-largeur de chaque poutre définit un axe de pivot R de ladite masse sismique. En d'autres termes, les poutres autorisent la rotation de la masse dans le plan XY (les poutres sont fines, vues dans le plan et opposent ainsi une faible raideur de flexion à la rotation dans le plan) autour de l'axe de pivot R. En outre, elles bloquent les autres déplacements dans le plan par leur forte raideur en compression, et elles bloquent également les mouvements hors plan par leur forte raideur en flexion hors plan (les poutres sont épaisses vues perpendiculairement au plan).

Les deux poutres forment ainsi une liaison charnière, ou liaison pivot, dont l'axe R est perpendiculaire au plan du substrat (l'axe R est parallèle à l'axe Z), axe autour duquel la masse sismique peut pivoter sous l'effet de l'accélération.

Une accélération selon l'axe sensible (ici l'axe Y1, qui est parallèle à l'axe Y) entraîne la rotation de la masse dans le plan XY autour de l'axe pivot R. Cette rotation actionne une jauge 8 (ou les jauges, par exemple une jauge fonctionnant en compression pendant qu'une autre jauge fonctionnant en traction), mécaniquement liée(s) à la masse sismique et au substrat. La jauge (ou les jauges) mesure(nt) le déplacement de la masse.

Il est ensuite possible d'en déduire l'accélération.

Avantageusement, la jauge de contrainte est placée près de la charnière, afin de bénéficier d'un bras de levier.

Les accéléromètres hors plan fonctionnent sur le même principe. La charnière est alors réalisée par des barres de torsion et/ou des barres en flexion hors plan qui peuvent être amincies pour être moins raides.

Le gain du bras de levier est donné par le rapport entre la longueur du bras de levier, c'est à dire la distance $D_{bras}$ entre le centre de rotation R formé par la charnière et le centre de gravité G de la masse où s'applique la force résultante de l'accélération, et la distance $D_{jauge}$ entre le centre de rotation R et le point de contact J de la jauge 8 sur la masse.

Le bras de levier permet de régler la sensibilité de l'accéléromètre. La sensibilité est donc fonction du rapport $D_{bras}/D_{jauge}$, et augmente avec la longueur du bras de levier.

En revanche, la fréquence de résonance propre de la masse diminue avec la longueur du bras de levier. Et elle diminue aussi avec le moment d'inertie de la masse (plus précisément avec la racine carrée du moment d'inertie). Ceci peut être démontré comme ce qui suit.

Le moment apporté par une jauge au niveau de la charnière est donné par le produit de la force de la jauge par la distance $D_{jauge}$ :

$$M_{jauge} = F_{Jauge}D_{jauge}$$

La jauge fonctionnant comme un ressort, la force qu'elle fournit est le produit de sa raideur par sa compression/son étirement :

$$F_{jauge} = K_{jauge}\delta l_{jauge}$$

La compression/l'étirement de la jauge est donné(e) par le produit de l'angle du bras de levier par la distance au centre de rotation :

$$\delta l_{jauge} = \alpha D_{jauge}$$

De ces trois équations, nous pouvons déduire la raideur angulaire fournit par une jauge sur le bras de levier :

$$C_{jauge} = \frac{M_{jauge}}{\alpha} = K_{jauge}D_{jauge}^2$$

Pour simplifier le raisonnement, on considère que la charnière est dimensionnée pour que sa raideur angulaire soit négligeable par rapport à celle des jauges. L'autre caractéristique pour obtenir la fréquence de résonance de la masse est son moment d'inertie.

Si on considère dans un premier temps que la masse est ponctuelle, alors le moment d'inertie est alors donné par le produit de son poids par le carré de la distance $D_{bras}$ :

$$I = mD_{bras}^2$$

La fréquence de résonance de la masse est donnée par la racine du rapport raideur angulaire sur inertie de la masse :

$$\omega_0 = \sqrt{\frac{C_{jauge}}{I}} = \frac{D_{jauge}}{D_{bras}}\sqrt{\frac{K_{jauge}}{m}}$$

Les inventeurs cherchent à augmenter la fréquence de résonance de la masse, en particulier pour pouvoir détecter des phénomènes dont la fréquence est plus haute (il faut que la fréquence de résonance soit supérieure à la fréquence que l'on souhaite détecter). On comprend de l'équation ci-dessus que ceci est en contradiction avec l'augmentation de la sensibilité par le bras de levier $D_{bras}/D_{jauge}$.

On cherche également à appliquer la force la plus importante à la jauge pour une masse donnée. La force récoltée par la masse est égale à l'accélération récoltée multipliée par le poids de la masse, soit :

$$Force = m\gamma$$

Donc si on veut augmenter la force récoltée par la masse, on peut augmenter le poids de la masse (rapport $\Delta m$). Or, la fréquence est également inversement proportionnelle à la racine du poids $m$ de la masse. Si on augmente ainsi la force d'un facteur égal à $\Delta m$. on diminue la fréquence de racine de $\Delta m$. Au final, on obtient un meilleur compromis d'une valeur égale à une racine de $\Delta m$.

Le problème est que le fait d'augmenter le poids de la masse se fait en augmentant la taille de la masse, et au final de l'accéléromètre. Or on cherche à limiter la taille de l'accéléromètre pour notamment en limiter le coût.

En outre, le moment d'inertie de la masse n'est pas strictement celui d'une masse ponctuelle, la masse étant davantage proche d'un rectangle de longueur $L_{masse}$ et de largeur $l_{masse}$ que d'un point. Un tel rectangle, maintenu en rotation par le milieu de sa largeur présente en fait un moment d'inertie plus grand qu'une masse ponctuelle :

$$I = \frac{m}{3}\left[L_{mass}^2 + \frac{l_{mass}^2}{4}\right]$$

Lorsque cette masse se rapproche d'un carré de côté $2D_{bras}$, le moment d'inertie est en fait 5/3 fois celui d'une masse ponctuelle, avec l'incidence sur la fréquence de résonance qu'on a vu précédemment.

$$\omega_0 = \sqrt{\frac{C}{I}} = \frac{D_{jauge}}{D_{bras}}\sqrt{\frac{K_{jauge}}{\frac{5}{3}m}}$$

On comprend donc qu'il existe un compromis entre les 3 paramètres que sont : la taille de la masse (et donc le poids de la masse), la sensibilité de l'accéléromètre et la fréquence de résonance de la masse.

Il est recherché notamment un accéléromètre qui, à fréquence de résonance et sensibilité données, utilise la masse minimum.

Un accéléromètre existe dans la demande de brevet FR2906038 dans lequel les mouvements de la masse et du bras de levier sont dissociés.

La figure 2 illustre une partie d'un accéléromètre selon la demande de brevet FR2906038. La masse 10 est animée d'un mouvement selon l'axe Oy, le mouvement de la masse en translation est transféré à l'extrémité d'un bras de levier 30 par l'intermédiaire d'une liaison 36 entre la masse sismique 10 et le bras de levier 30.

Il y a deux bras de levier et deux liaisons. Chaque bras de levier est disposé sur un bord de la masse. Chaque bras de levier est par ailleurs maintenu en rotation autour de l'axe Oz grâce à une liaison charnière formée par deux bras flexibles 38 et 40. Ladite liaison 36 est élastique dans la direction Ox (perpendiculaire à Oy) mais rigide dans la direction Oy (et doit absorber l'angle de rotation).

La liaison 36 entre la masse sismique et le bras de levier peut être un bras flexible rectiligne allongé dans la direction Oy, mais mince dans la direction Ox, de sorte qu'il peut fléchir dans la direction Ox.

Ainsi seul le bras de levier 30 est en rotation, et non pas toute la masse 10, ce qui permet de diminuer l'inertie de la masse. La masse étant en translation, elle agit comme une masse ponctuelle en bout de bras de levier (plutôt qu'une masse de type rectangulaire). Ainsi, avec cette configuration, on peut théoriquement obtenir la même sensibilité et la même fréquence de résonance avec une masse en translation 5/3 fois plus petite qu'une masse carrée en rotation.

Le déplacement en rotation du bras de levier est transmis à une poutre résonante 20.

Cependant, dans la demande de brevet FR2906038, on constate qu'il doit y avoir nécessairement une symétrie autour de l'axe Ox, c'est-à-dire perpendiculairement à l'axe sensible Oy. En effet, il faut nécessairement deux bras de levier 30 et 30' pour une masse 10, ceci, pour éviter que la masse ne tourne sous l'effet de l'accélération selon l'axe sensible Oy.

Cela entraîne un risque, en cas de symétrie imparfaite, que la masse tourne également en même temps que l'un ou l'autre des deux bras de levier, ce qui a pour conséquence d'augmenter à nouveau le moment d'inertie de la masse et donc de diminuer la fréquence de résonance.

En outre, il y a une jauge (poutre résonante) 20, 20' par bras de levier 30, 30' et, du fait de la symétrie, les jauges (poutres résonantes) ne sont pas côte à côte. Or, du fait du procédé de fabrication d'un accéléromètre (micro-usinage dans une plaque de matériau monolithique, tel un silicium sur isolant (SOI)), deux jauges ont d'autant plus de différences entre elles qu'elles sont éloignées l'une de l'autre. Les différences sont telles que cela induit une perte de précision, notamment lorsqu'on réalise une mesure différentielle, et qu'il est généralement nécessaire de recaler les signaux entre les deux jauges.

Les bras de levier peuvent aussi créer des différences au niveau des jauges s'ils ne sont pas parfaitement semblables.

L'invention vise à surmonter les inconvénients précités de l'art antérieur.

Il est donc recherché un accéléromètre qui permette d'augmenter le produit fréquence de résonance x sensibilité pour un même encombrement, et qui soit précis, notamment lors de l'utilisation de deux jauges de contraintes pour une mesure différentielle.

EXPOSE DE L'INVENTION

L'invention permettant d'atteindre ce but est un accéléromètre MEMS ou NEMS apte à mesurer une accélération selon un axe sensible comprenant :

- un substrat présentant un plan ;
- une masse présentant une zone centrale et suspendue par rapport au substrat;
- un unique bras de levier formant structure d'amplification d'effort de la masse, comprenant :

    • une première extrémité reliée au substrat par l'intermédiaire d'une première liaison apte à autoriser la rotation du bras de levier autour d'un axe de rotation perpendiculaire à l'axe sensible, et
    • une seconde extrémité reliée à la masse par l'intermédiaire d'une seconde liaison apte à transmettre le mouvement de translation de la masse au bras de levier tout en autorisant la rotation dudit bras de levier autour de l'axe de rotation ;

    la seconde extrémité du bras de levier étant disposée au niveau de la zone centrale de la masse ;
- au moins une jauge de contrainte, ladite jauge étant reliée au bras de levier, chaque jauge comprenant :

    • une première extrémité reliée au substrat, et
    • une seconde extrémité reliée au bras de levier.

On nomme « axe sensible » l'axe de l'accélération à mesurer.
Les termes « épaisseur », « épais », « minceur », « mince » sont donnés pour des dimensions perpendiculaires au plan du substrat.
Les termes « fin », « finesse », « large », « largeur », « allongé », « allongement », « longueur », « long » sont donnés pour des dimensions dans le plan du substrat (ou dans un plan parallèle au plan du substrat).
Par « couplage », on entend la liaison de deux pièces de manière à permettre la transmission mécanique de l'une à l'autre selon au moins un axe.
L'accéléromètre selon l'invention comprend un seul bras de levier, qu'il y ait une ou deux jauges de contraintes (voire plus de deux jauges).
En outre, le bras de levier et la masse ont des mouvements différenciés, la masse ne tournant pas (ou très peu).
Enfin, le point de liaison du bras de levier avec la masse est disposé au cœur de ladite masse. Le bras de levier n'est pas disposé sur un côté de la masse.
La masse agit sur au moins une jauge de contraintes par l'intermédiaire du bras de levier.
L'invention permet de conserver un meilleur compromis entre la taille de la masse (et donc le poids de la masse), la sensibilité de l'accéléromètre et la fréquence de la masse.
Notamment pour un accéléromètre de masse donnée, elle permet d'obtenir un meilleur produit fréquence de résonance x sensibilité.
En outre, il n'y a plus d'erreur due à l'utilisation de deux bras de levier qui sont en général ni parfaitement identiques, ni disposés de manière parfaitement symétrique par rapport à la masse.
Enfin, lors du procédé de fabrication NEMS/MEMS, et notamment lors du collage de l'ensemble substrat-masse-levier-plots-liaisons-jauge(s) (ensemble aussi nommé « puce ») dans un boîtier, il peut se produire une légère déformation de la puce. Ces déformations se répercutent d'autant plus que les plots d'ancrage sur le substrat sont éloignés les uns des autres, et elles induisent des défauts de mesure. De telles déformations peuvent également se produire en cas de dilatation thermique de la puce.
Ceci est particulièrement critique pour les ancrages de chaque jauge et pour les ancrages des liaisons de type charnière qui doivent donc avantageusement être proches les uns des autres.
L'accéléromètre selon l'invention permet de disposer un maximum d'ancrages proches les uns des autres, c'est-à-dire disposés dans une zone réduite, en particulier, surtout lorsqu'il y a plusieurs jauges, pour les ancrages des jauges. Ainsi, les défauts se répercutent moins d'une jauge à une autre. Ceci permet d'obtenir une mesure encore plus précise.
Cela permet en outre d'obtenir une mesure plus stable (moins de dérive en température notamment).
En d'autres termes, les effets du stress du substrat, notamment dus au collage de la puce et aux différentes dilatations thermiques, sont grandement diminués grâce à la proximité des ancrages.
Selon un mode de réalisation avantageux, l'accéléromètre comprend au moins deux jauges de contrainte.
Lors de l'utilisation de deux jauges de contraintes, qui permet notamment une mesure différentielle, l'invention permet d'avoir les deux jauges très proches sur un unique bras de levier, ce qui permet d'obtenir une mesure bien plus précise. En effet, pour rappel, du fait du procédé de fabrication NEMS ou MEMS, deux jauges proches sont beaucoup plus semblables que deux jauges éloignées. L'accéléromètre selon l'invention permettant de rapprocher les jauges, il y a moins d'erreurs dues aux différences entre les deux jauges. En d'autres termes, les variations technologiques entre deux jauges sont réduites grâce à la proximité desdites jauges, ce qui induit une meilleure mesure différentielle, sans avoir à recaler les signaux des deux jauges.
Selon un mode de réalisation particulier, les deux jauges de contrainte sont disposées de part et d'autre de la première extrémité du bras de levier. Ceci permet de réaliser une meilleure mesure différentielle.

Selon un mode de réalisation, la masse est suspendue par rapport au substrat par au moins une troisième liaison apte à autoriser la translation de ladite masse selon l'axe sensible.

Selon un mode de réalisation particulier, au moins une troisième liaison comprend une lame souple selon l'axe sensible.

Selon un mode de réalisation particulier, l'accéléromètre comprend plusieurs troisièmes liaisons réparties de manière équilibrée par rapport au centre de gravité de la masse.

Selon un autre mode de réalisation, la masse est suspendue par rapport au substrat uniquement par le bras de levier.

Selon un mode de réalisation, la seconde extrémité du bras de levier est disposée au niveau du centre de gravité de la masse.

Selon un autre mode de réalisation, la seconde extrémité du bras de levier est décalée par rapport au centre de gravité de la masse. Cela permet d'éviter une rotation non souhaitée de la masse.

Selon une première variante de l'invention, l'axe sensible est dans le plan du substrat.

Selon un mode de réalisation particulier, la première extrémité du bras de levier présente une forme amincie selon l'axe sensible.

Selon un mode de réalisation particulier, la première liaison comprend deux lames non parallèles, formant une charnière apte à permettre la rotation du bras de levier selon l'axe de rotation perpendiculaire à l'axe sensible.

Selon un mode de réalisation avantageux, les deux lames sont perpendiculaires entre elles. Cela permet d'avoir une même raideur selon les deux axes perpendiculaires.

Selon un mode de réalisation particulier, la seconde liaison comprend une lame de couplage rigide selon l'axe sensible, et souple selon l'axe de rotation du bras de levier. Cela permet d'éviter de transmettre au levier un mouvement ou un choc dans le plan qui ne soit pas dans l'axe sensible.

Selon un autre mode de réalisation particulier, la seconde liaison comprend un fil de couplage rigide selon l'axe sensible, et souple selon les axes perpendiculaires audit axe sensible. Cela permet en outre d'éviter de transmettre au levier un mouvement ou un choc hors plan.

Selon une seconde variante de l'invention, l'axe sensible est perpendiculaire au plan du substrat.

Selon un mode de réalisation particulier, la première liaison comprend deux lames colinéaires, configurées de manière à former l'axe de rotation du bras de levier.

Selon un mode de réalisation particulier, la seconde liaison comprend une lame de couplage principale rigide selon l'axe sensible et souple selon l'axe de rotation. Cela permet d'éviter de transmettre au levier un mouvement ou un choc selon au moins un axe dans le plan.

Selon un mode de réalisation particulier, la seconde liaison comprend en outre au moins une lame de couplage secondaire reliée à la lame de couplage principale et perpendiculaire à ladite lame de couplage principale. Cela permet d'éviter de transmettre au levier un mouvement ou un choc selon les deux axes du plan.

De préférence, l'épaisseur du bras de levier est sensiblement égale à celle de la masse, ce qui facilite beaucoup le procédé de fabrication

De préférence, l'épaisseur d'une jauge de contrainte est inférieure à l'épaisseur de la masse. La réduction de l'épaisseur d'une jauge, et donc de sa section, permet de concentrer les contraintes qu'elle subit du fait du déplacement de la masse, dans une section réduite, ce qui a pour effet d'augmenter la sensibilité de l'accéléromètre.

Par ailleurs, le fait de réaliser le bras de levier/la masse et la jauge suivant des épaisseurs différentes, permet de les découpler, et ainsi de les optimiser séparément.

L'épaisseur de la masse et du bras de levier est de préférence comprise entre 1 et 100 $\mu$m, par exemple inférieure ou égale à 50 $\mu$m, et en général 20 $\mu$m (valeur bien adaptée à l'épitaxie).

L'épaisseur d'une jauge est de préférence comprise entre 0,1 $\mu$m et 1,0 $\mu$m.

L'épaisseur de la première liaison formant pivot peut être égale à celle de la masse, ou à celle de la jauge, ou être comprise entre les deux.

L'épaisseur de la seconde liaison formant liaison de couplage/découplage peut être égale à celle de la masse, ou à celle de la jauge, ou être comprise entre les deux.

DESCRIPTION DES FIGURES

D'autres caractéristiques et avantages de l'invention apparaîtront à l'aide de la description qui suit donnée à titre illustratif et non limitatif, faite en regard des figures annexées parmi lesquelles :

- la figure 1 illustre un accéléromètre de l'état de la technique ;
- la figure 2 illustre un autre accéléromètre de l'état de la technique ;
- la figure 3 illustre un accéléromètre selon un premier mode de réalisation ;
- la figure 4A et 4B illustrent deux variantes d'un premier détail d'un accéléromètre selon le premier mode de réalisation ;
- les figures 5A et 5B illustrent deux variantes d'un second détail d'un accéléromètre selon le premier mode de réalisation ;
- les figures 6A et 6B illustrent deux variantes d'un troisième détail d'un accéléromètre selon le premier mode de réalisation ;
- la figure 7 illustre un accéléromètre selon un second mode de réalisation ;

- la figure 8A et 8B illustrent deux variantes d'un premier détail d'un accéléromètre selon le second mode de réalisation ;
- la figure 9 illustre un second détail d'un accéléromètre selon le second mode de réalisation ;
- les figures 10A et 10B illustrent deux variantes d'un troisième détail d'un accéléromètre selon le second mode de réalisation ;
- la figure 11 illustre un mode de réalisation particulier de l'invention.

## EXPOSÉ DÉTAILLÉ DE MODES DE RÉALISATION PARTICULIERS

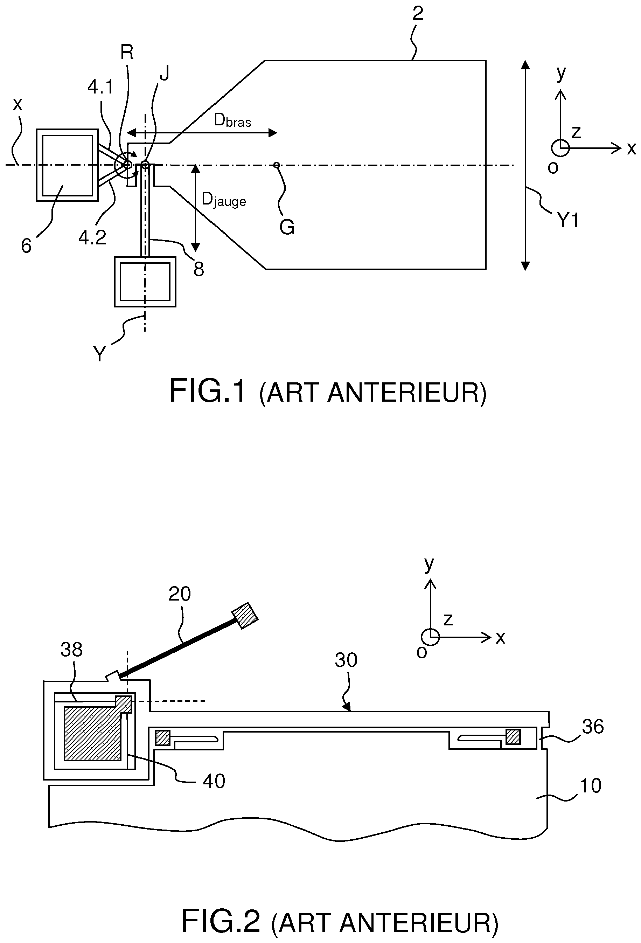

Les figures 1 et 2 qui illustrent des accéléromètres de l'état de la technique ont déjà été décrites plus avant et ne seront pas reprises ici.

Dans l'ensemble de la description, un point d'ancrage sur le substrat peut également nommé « plot » ou « plot d'ancrage ».

Il s'agit généralement de plots d'ancrage en silicium.

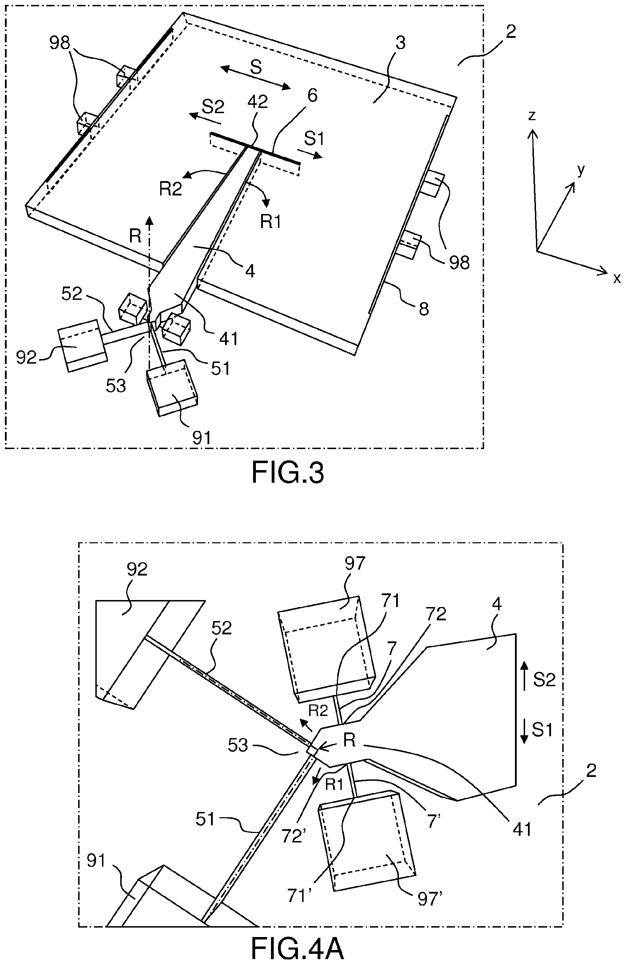

Les figures 3, 4A, 4B, 5A, 5B, 6A et 6B illustrent un accéléromètre selon un premier mode de réalisation de l'invention, qui est un accéléromètre dans le plan.

Un accéléromètre est dit « dans le plan », lorsque l'axe sensible de déplacement de la masse mobile se situe dans un plan parallèle au substrat.

L'accéléromètre 1 selon le premier mode de réalisation comporte une masse 3 destinée à être déplacée sous l'effet d'un effort extérieur, en l'occurrence sous l'effet d'une accélération selon un axe sensible S situé dans le plan du substrat, ici dans le plan XY. La masse 3 est mobile en translation selon l'axe sensible S par rapport au substrat 2.

Dans l'exemple illustré, l'axe sensible S est parallèle à l'axe X. Ils pourront être confondus dans la description du premier mode de réalisation.

Dans l'exemple illustré, la masse mobile 3 est suspendue au-dessus du substrat 2 au moyen d'au moins une troisième liaison 8. Un plot d'ancrage 98 fixe une troisième liaison 8 au substrat 2. La troisième liaison est optionnelle.

Dans l'exemple illustré, il y a plusieurs (quatre) troisièmes liaisons 8 disposées sur les côtés de la masse.

Chaque troisième liaison 8 est attachée au substrat 2 par l'intermédiaire d'un point d'ancrage 98. Les quatre troisièmes liaisons sont réparties de manière régulière sur les deux côtés de la masse perpendiculaires à l'axe sensible S. Ainsi, les troisièmes liaisons maintenant la masse sont réparties de manière équilibrée par rapport au centre de gravité. Ceci évite d'induire un couple lors de la translation de la masse.

Les troisièmes liaisons maintiennent la masse mobile 3 sensiblement parallèle au substrat 2.

La combinaison des troisièmes liaisons aboutit essentiellement à un seul degré de liberté.

Dans l'exemple illustré, la combinaison des troisièmes liaisons a essentiellement comme seul degré de liberté la translation selon l'axe sensible S. Dans la réalité, les troisièmes liaisons ne sont pas parfaitement rigides selon les autres axes de sorte que des mouvements selon d'autres degrés de liberté en translation ou en rotation restent possibles, mais ces mouvements sont négligeables devant le mouvement de translation selon l'axe sensible S. En outre, c'est la combinaison de plusieurs troisièmes liaisons qui empêche la masse de tourner dans le plan, de sorte qu'on peut considérer pour simplifier qu'il n'y a qu'un degré de liberté en translation selon ledit axe sensible.

Les troisièmes liaisons comprennent par exemple des lames souples dans l'axe sensible, mais raides dans les autres axes. De telles liaisons peuvent être réalisées en utilisant des lames suffisamment fines et par conséquent flexibles dans l'axe sensible. Elles peuvent être plus larges et épaisses, et par conséquent plus raides, dans un autre axe ou dans tous les autres axes. Par exemple (non représenté), elles peuvent être épaisses dans l'axe Z, mais fines dans l'axe Y (voire aussi fines que dans l'axe Y que dans l'axe X), ce qui permet d'obtenir une raideur de compression très supérieure à la raideur de flexion pour une lame.

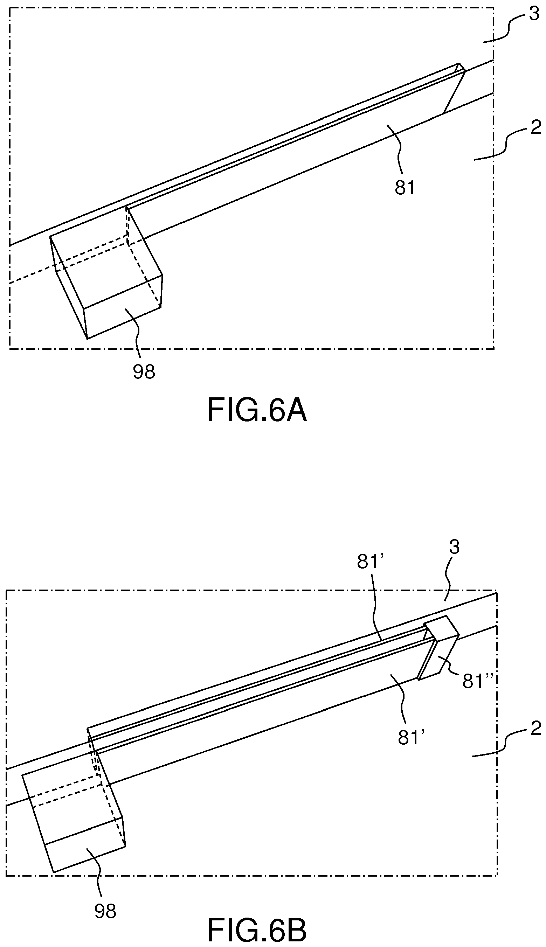

La figure 6A illustre un premier exemple de troisième liaison formée par une lame unique allongée selon l'axe Y et fine selon l'axe X qui est parallèle à l'axe sensible S. Chaque lame 81 relie un plot 98 à la masse 3. Dans le plan de l'accéléromètre, une telle lame a une forte raideur dans le sens de son allongement (axe Y) et une faible raideur selon l'axe perpendiculaire à son allongement (axe X). En outre, la lame possède aussi une raideur suffisante selon l'axe Z pour ne pas autoriser de déplacements de la masse dans ledit axe.

La figure 6B illustre un second exemple de troisième liaison formée par une double lame, les deux lames 81, 81' se rejoignant en formant un U, chaque lame étant allongée selon l'axe Y et fine selon l'axe X qui est parallèle à l'axe sensible S. Une première lame 81 est reliée à un plot 98 et une seconde lame 81' est reliée à la masse 3. Les deux lames 81 et 81' sont par ailleurs reliées entre elles par une pièce de liaison intermédiaire 81".

Par rapport à une simple lame, une telle double lame fournit moins de raideur selon les axes perpendiculaires à l'axe sensible, mais fournit une réponse au déplacement de la masse beaucoup plus linéaire.

D'autres solutions existent pour réaliser une troisième liaison, c'est-à-dire pour autoriser un mouvement de translation de la masse 3 par rapport au substrat 2 selon l'axe sensible.

Alternativement, la liaison entre le substrat et la masse peut être réalisée uniquement et directement par le bras de levier 4.

Encore alternativement, la liaison entre le substrat et la masse peut être réalisée par un ou plusieurs points d'ancrage disposés sur le substrat et situés en partie centrale et en dessous de la masse mobile (entre la masse et le substrat), et par des bras de liaison élastiques allongés selon l'axe Y reliant la masse et ce ou ces points d'ancrage.

La masse mobile 3 présente une zone détourée de manière à former un bras de levier 4, qui présente au moins un degré de liberté par rapport à la masse 3.

Le bras de levier 4 comprend une première extrémité 41 reliée au substrat 2 au moyen d'une première liaison 5. Cette première liaison peut être nommée « liaison pivot ». Le bras de levier est ainsi suspendu audessus du substrat 2.

La première liaison 5 maintient le bras de levier 4 sensiblement parallèle au substrat 2.

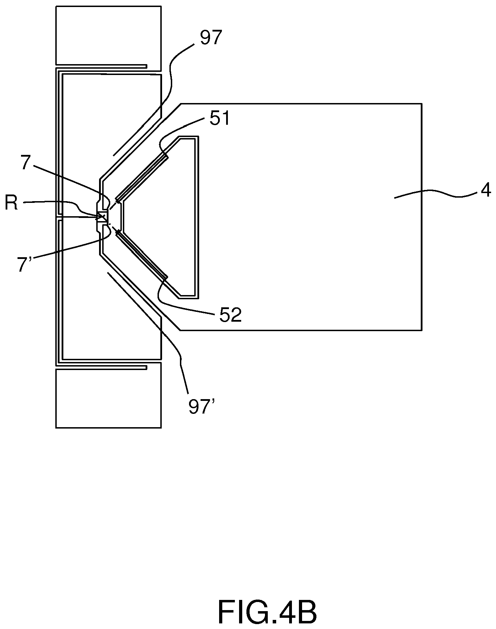

La première liaison 5 peut être réalisée avantageusement comme illustré dans la figure 4. Elle comprend deux lames 51 et 52. Chaque lame 51, 52 présente, dans le plan XY du substrat, une dimension allongée (longueur) définissant sa direction longitudinale et une dimension fine (largeur). Chaque lame est reliée au substrat 2 par l'intermédiaire d'un point d'ancrage 91, 92.

Les deux lames sont non parallèles. L'intersection des lames, et plus précisément d'axes s'étendant selon la direction longitudinale de chaque lame et situés sur la demi-largeur de chaque lame se croisent pour former un axe de rotation R perpendiculaire au plan du substrat.

Ici l'axe de rotation R est parallèle à selon l'axe Z, ils pourront être confondus dans la description du premier mode de réalisation.

Une charnière 53 est formée par les deux lames, fournissant l'axe de rotation R du bras de levier 4.

La charnière est maintenue fixe par les fortes raideurs en compression selon la direction longitudinale de chacune des lames. Cependant, lesdites lames peuvent être entrainées en flexion avec le bras de levier 4, autorisant ainsi la rotation dudit bras de levier.

Les lames peuvent être avantageusement placées orthogonalement entre elles pour présenter la même raideur en X et Y.

La charnière 53 autorise ainsi un mouvement de rotation du bras de levier 4 dans le plan du substrat autour de l'axe de rotation R. L'intersection de l'axe de rotation R avec le plan forme un centre de rotation.

Dans l'exemple représenté, l'épaisseur des lames 51, 52 et donc de la charnière 53 est égale à celle de la masse 3.

Dans l'exemple illustré, deux jauges de contraintes 7, 7' sont illustrées bien qu'une seule jauge peut être mise en place (ou plus de deux jauges).

La figure 4A illustre plus précisément une première configuration des deux jauges de contrainte 7 et 7'. Chaque jauge 7, 7' est allongée dans l'axe sensible S, et est fine et mince dans les autres axes Y et Z. Chaque jauge comprend une première extrémité 71, 71' reliée au substrat 2, par l'intermédiaire de plots d'ancrage 97, 97'.

Dans l'exemple illustré, les deux jauges de contrainte sont disposées de part et d'autre de la première extrémité 41 du bras de levier. Cela permet d'avoir une jauge qui fonctionne en compression pendant que l'autre fonctionne en étirement, ce qui permet de réaliser une bonne mesure différentielle.

Par ailleurs, dans la première configuration illustrée en figure 4A, les lames forment une charnière souple. Par contre, une jauge n'est pas disposée perpendiculairement à l'axe reliant le centre de rotation et le centre de la jauge, ce qui peut créer des déformations parasites de la jauge.

Les jauges peuvent être disposées selon toute autre configuration par rapport au bras de levier.

Il y a une seule structure d'amplification (un seul bras de levier) pour les deux jauges.

Dans l'exemple représenté, les deux jauges de contraintes 7, 7' sont disposées de manière symétrique par rapport à l'axe Y. En outre, elles sont allongées selon l'axe X, c'est-à-dire parallèles à l'axe sensible S.

Chaque jauge 7, 7' comprend une seconde extrémité 72, 72' reliée au bras de levier 4.

Les jauges peuvent être allongées selon un axe différent de l'axe sensible, et disposées selon une seconde configuration comme illustré dans la figure 4B.

Dans cette seconde configuration, les deux jauges 7, 7' sont parallèles entre elles et reliées chacune à un ancrage 97, 97' et au bras de levier 4 (la masse 3 est non représentée sur la figure).

Chaque jauge est ainsi placée perpendiculairement à l'axe reliant l'axe de rotation R et le centre de la jauge. Cela permet que chaque jauge travaille en compression, ait un mouvement de flexion angulaire pur et soit moins contrainte par des mouvements parasites.

Par contre, dans cette configuration, les deux lames formant la charnière ne peuvent se joindre directement, ce qui augmente la raideur angulaire de la charnière. Le pivot est moins bon.

Lors d'une accélération, la masse 3 est mise en mouvement selon l'axe S, soit dans le sens S1, soit dans le sens S2. La translation de la masse 3 est transférée au levier 4 qui la transforme en mouvement de rotation selon l'axe de rotation R, soit dans le sens R1, soit dans le sens R2.

Le déplacement en rotation (selon un arc de cercle R1 ou R2 sur le plan XY du substrat) du bras de levier 4 et donc de la première extrémité 41 dudit bras de levier applique une contrainte sur chaque jauge 7, 7', qui est soit une contrainte en compression pour la jauge vers laquelle le déplacement est orienté, soit une contrainte en traction pour l'autre jauge. Ainsi, une jauge fonctionne en compression tandis que l'autre jauge fonctionne en traction, ce qui permet une mesure différentielle.

Comme illustré, la première extrémité 41 du bras de levier 4 présente de préférence une forme effilée, c'est-à-dire plus fine selon l'axe X par rapport au reste du bras de levier. Ainsi, la liaison mécanique entre chaque jauge et le bras de levier se situe au plus près du plan contenant le centre de gravité de la masse et l'axe de rotation R. Ainsi, le mouvement du bras de levier est parallèle à la jauge. Cela a pour avantage d'avoir un mouvement de compression/étirement de la jauge le plus pur possible (sans flexion).

Les jauges sont en outre ainsi placées proches de la charnière 53 pour bénéficier au mieux de l'amplification obtenue par le bras de levier.

Le bras de levier 4 comprend une seconde extrémité 42 reliée à la masse 3, via une seconde liaison 6. Cette seconde liaison peut également être nommée « liaison de couplage » ou « liaison de couplage/découplage ». Elle doit transmettre le mouvement de la masse selon l'axe sensible S au bras de levier, et faire cohabiter la translation de la masse avec la rotation dudit bras de levier.

Cette seconde liaison entre le bras de levier et la masse est disposée dans la partie centrale de la masse.

La seconde liaison peut comprendre une lame de couplage ou un fil de couplage.

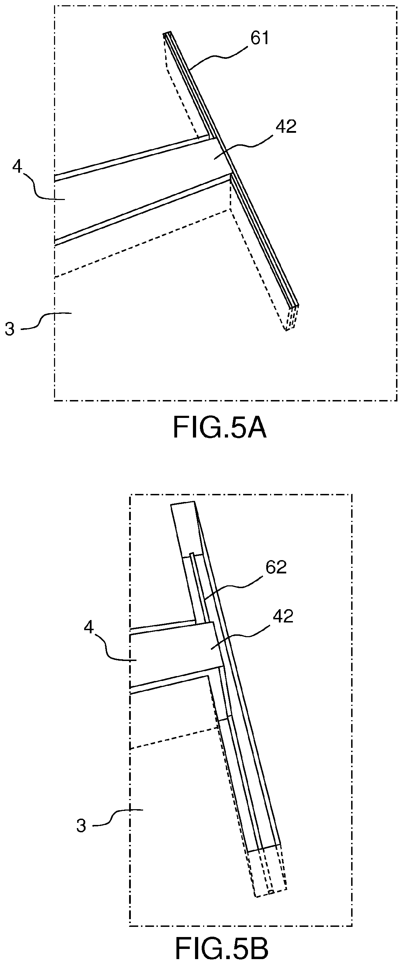

La figure 5A illustre une première variante de seconde liaison, qui est une lame de couplage.

La flexion de la lame selon l'axe Y permet de faire cohabiter le déplacement en arc de cercle du bout du bras de levier en rotation, avec le déplacement en ligne droite de la masse en translation.

La lame de couplage 61 est une lame allongée selon l'axe X de manière à être suffisamment rigide pour transmettre le mouvement de translation de la masse 3 au bras de levier 4, et fine selon l'axe Y de manière à autoriser la rotation du bras de levier 4 par rapport à la masse 3.

Grâce à une telle lame de couplage, le déplacement de la masse dans l'autre axe du plan (l'axe Y) n'est pas transmise au bras de levier, puisqu'au contraire la lame fléchit dans cet axe du fait de sa finesse (on dit qu'elle induit un découplage). Ceci confère un avantage en cas de choc dans ledit axe, lequel choc n'est pas transféré au bras de levier. Cela ne vient ainsi pas parasiter le mouvement transmis par la masse via le bras de levier et mesuré par la (ou les) jauge(s).

Par contre, la lame de couplage 61 présente une épaisseur non négligeable (la lame de couplage est dans la même couche épaisse que la masse 3). Cela lui confère une raideur non nulle dans cet axe, ce qui fait qu'un choc hors plan peut être transmis au bras de levier.

La lame de couplage peut être réalisée lors de la gravure profonde qui permet de graver la couche épaisse, comme pour la masse et la charnière.

La figure 5B illustre une seconde variante de seconde liaison, qui est un fil de couplage.

Un fil de couplage 62 présente, par définition, une épaisseur plus faible par rapport à une lame de couplage. Ainsi, cela permet en plus de découpler le déplacement de la masse 3 selon l'axe Z. Les autres dimensions sont équivalentes à celles de lame de couplage. Cependant, la dimension selon l'axe Y peut être plus courte pour compenser les raideurs réduites (n'apparait pas sur la figure). Un tel fil de couplage présente donc de faibles raideurs dans les axes Y et Z, et une forte raideur dans l'axe X.

Le fil de couplage peut être réalisé lors de la gravure de la couche fine, tout comme les jauges de contraintes.

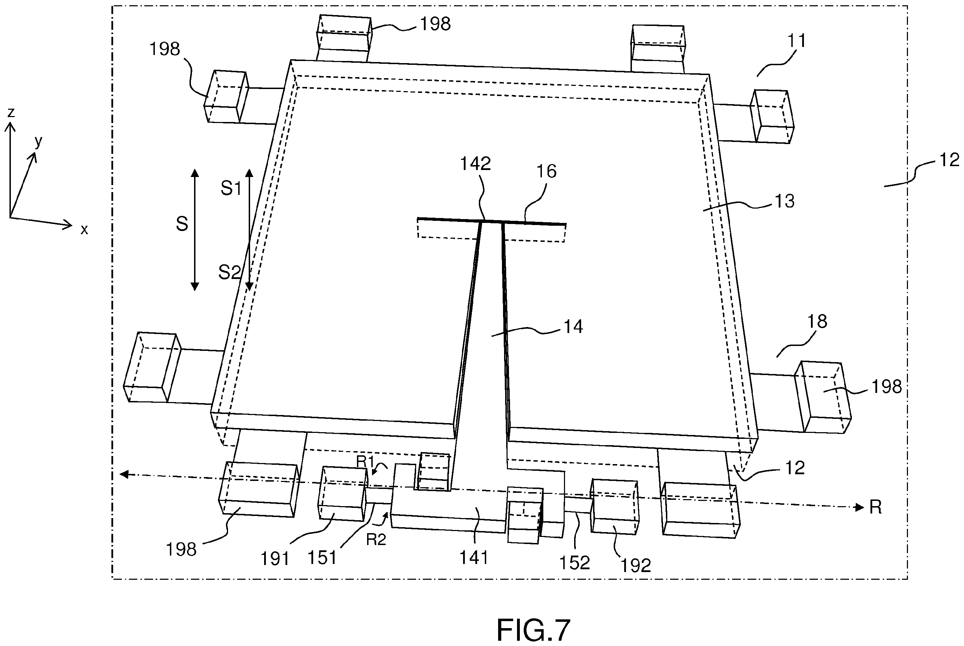

Les figures 7, 8A, 8B, 9, 10A et 10B illustrent un accéléromètre selon un second mode de réalisation de l'invention, qui est un accéléromètre hors plan.

Un accéléromètre est dit « hors plan », lorsque l'axe sensible de déplacement de la masse mobile se situe selon un axe perpendiculaire au plan du substrat.

L'accéléromètre 11 selon le second mode de réalisation comporte une masse 13 destinée à être déplacée sous l'effet d'un effort extérieur, en l'occurrence sous l'effet d'une accélération perpendiculaire au plan du substrat 12 selon un axe sensible S. Ici le plan du substrat est le plan XY, et l'axe sensible S est parallèle à l'axe Z. L'axe S et l'axe Z pourront être confondus dans la suite de la description du second mode.

La masse 13 est mobile en translation par rapport au substrat 12, selon un mouvement de translation dans l'axe sensible S.

La masse mobile 13 est suspendue au-dessus du substrat 12 au moyen d'au moins une troisième liaison 18. Au moins un plot d'ancrage 198 fixe la troisième liaison 18 au substrat 12.

La troisième liaison est optionnelle.

Dans l'exemple illustré, la troisième liaison est en fait constituée de plusieurs troisièmes liaisons 18 disposées sur les côtés de la masse. Chaque troisième liaison est attachée au substrat 2 par l'intermédiaire d'un plot d'ancrage 198.

Dans l'exemple représenté, les troisièmes liaisons sont réparties de manière régulière sur les quatre côtés de la masse 13. Ainsi, les troisièmes liaisons maintenant la masse sont réparties de manière équilibrée par rapport au centre de gravité de ladite masse. Ceci évite d'induire un couple lors de la translation de la masse.

Chaque troisième liaison a essentiellement un seul degré de liberté en translation (selon l'axe Z), mais peut avoir au moins un degré de liberté en rotation.

Selon l'exemple illustré, les troisièmes liaisons ont essentiellement comme seul degré de liberté la translation selon l'axe sensible S, les rotations hors plan, les translations et la rotation dans le plan étant bloquées par leur action commune. Dans la réalité, les translations et la rotation dans le plan ne sont pas parfaitement bloquées de sorte que ces mouvements restent possibles, mais ils sont négligeables devant les autres mouvements, et notamment le mouvement de translation selon l'axe sensible S. En outre, c'est la combinaison de plusieurs troisièmes liaisons qui empêche les mouvements dans le plan, de sorte qu'on peut considérer pour simplifier qu'il n'y a qu'un degré de liberté en translation selon ledit axe sensible.

Les troisièmes liaisons sont par exemple des lames souples dans l'axe sensible S, mais raides dans les autres axes. De telles liaisons peuvent être réalisées en utilisant des lames suffisamment minces et par conséquent flexibles dans l'axe sensible S, mais suffisamment larges et par conséquent raides dans les autres axes.

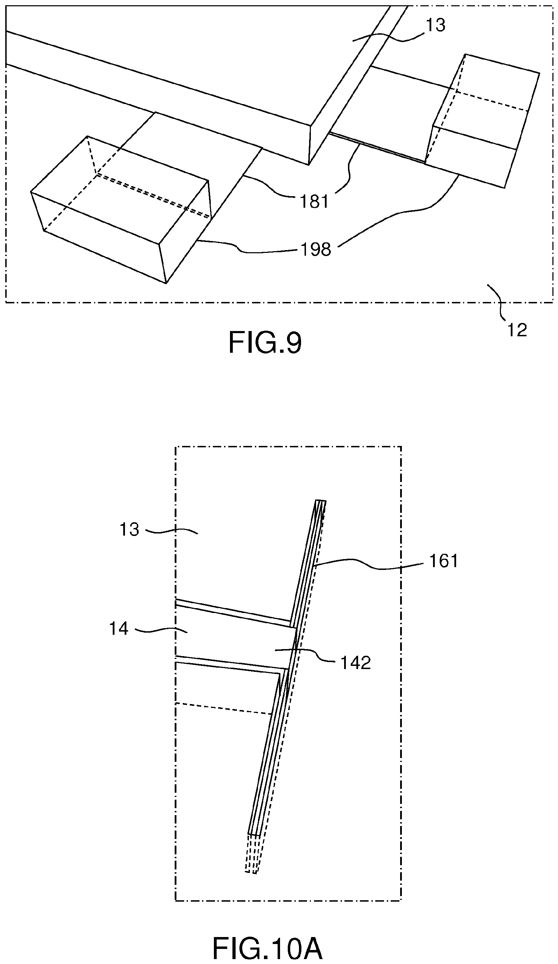

La figure 9 illustre un exemple de troisième liaison formée par une lame allongée selon les axes X et Y et mince selon l'axe Z qui est parallèle à l'axe sensible S. Comme il y a plusieurs troisièmes liaisons 18, il y a plusieurs lames 181. Chaque lame 181 est reliée à la masse 13 et à un plot d'ancrage198. Une lame 181 a une forte raideur dans le plan de l'accéléromètre et une faible raideur selon l'axe Z.

D'autres solutions existent pour réaliser une troisième liaison, c'est-à-dire autoriser un mouvement de translation de la masse 13 selon le substrat 12 selon l'axe sensible S.

Alternativement, la liaison entre le substrat et la masse peut être réalisée uniquement et directement par le bras de levier 14.

Encore alternativement, la liaison entre le substrat et la masse peut être réalisée par un ou plusieurs points d'ancrage fixés au substrat et situés en partie centrale et en dessous de la masse mobile (entre le substrat et la masse) et reliés à la masse par des bras de liaison élastiques selon l'axe Z.

La masse mobile 13 présente une zone détourée de manière à former un bras de levier 14, qui présente au moins un degré de liberté par rapport à la masse 13.

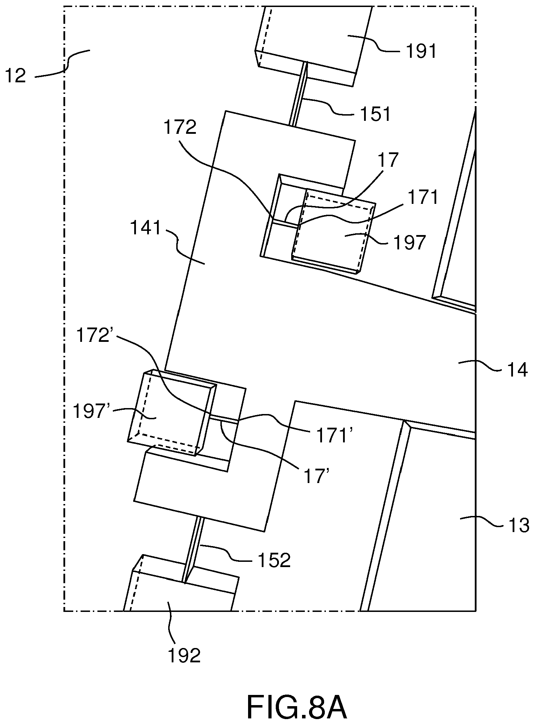

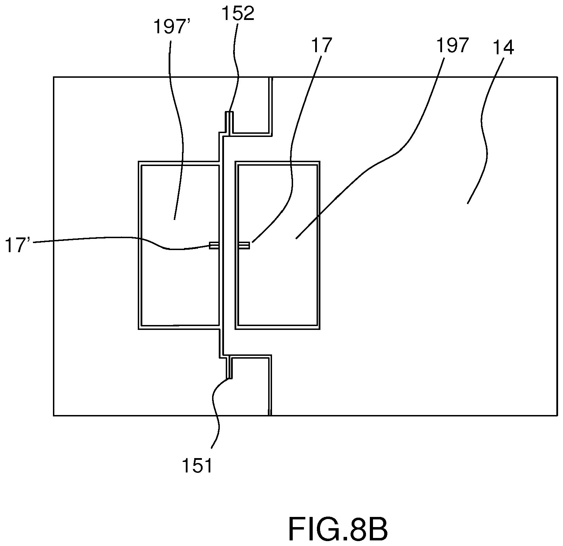

Le bras de levier 14 comprend une première extrémité 141 reliée au substrat 12 au moyen de deux lames 151 et 152 formant la première liaison 15. Cette première liaison peut être nommée « liaison pivot ». Le bras de levier 14 est ainsi suspendu au-dessus du substrat 12. Ceci est plus précisément illustré dans la figure 8.

Chaque lame 151, 152 est reliée au substrat 12 par l'intermédiaire d'un point d'ancrage 191, 192.

Dans l'exemple représenté, les deux lames 151 et 152 sont allongées selon l'axe X et sont colinéaires selon le même axe X. Elles sont fines selon l'axe Y et sont au nombre de deux de manière à ne former sensiblement qu'un degré de liberté, qui est une torsion autour d'un axe de rotation R qui est parallèle à l'axe X (et donc perpendiculaire à l'axe sensible). Dans la description du second mode de réalisation, les axes R et X pourront être confondus. Les deux lames 151, 152 autorisent un mouvement de rotation au bras de levier 14 autour dudit axe de rotation.

Dans l'exemple illustré, deux jauges de contraintes 17, 17' sont illustrées bien qu'une seule jauge peut être mise en place (ou plus de deux jauges).

La figure 8A illustre plus précisément une première configuration pour les deux jauges de contrainte 17 et 17'. Chaque jauge 17, 17' est allongée selon l'axe Y, et est fine et mince selon les autres axes X et Z. Chaque jauge comprend une première extrémité 171, 171' reliée au substrat 12, par l'intermédiaire de plots d'ancrage 197, 197'.

Les deux jauges de contrainte sont disposées de part et d'autre de la première extrémité 141 du bras de levier. Dans l'exemple représenté, les deux jauges de contraintes 17, 17' sont disposées de manière symétrique par rapport à l'axe X qui correspond à l'axe de rotation R. Cela permet d'avoir une jauge qui fonctionne en compression pendant que l'autre fonctionne en étirement, ce qui permet de réaliser une bonne mesure différentielle.

Les jauges peuvent être disposées selon toute autre configuration par rapport au bras de levier.

Il y a une seule structure d'amplification (un seul bras de levier) pour les deux jauges.

Chaque jauge 17, 17' comprend une seconde extrémité 172, 172' reliée au bras de levier 14.

Lorsque l'environnement connaît une accélération, la masse 13 est mise en mouvement le long de l'axe S, soit dans le sens S1, soit dans le sens S2. Le déplacement de la masse 13 en translation selon l'axe S est transféré à l'extrémité du levier 14, en rotation selon l'axe de rotation R, soit dans le sens R1, soit dans le sens R2.

Le déplacement en rotation du bras de levier 14 applique une contrainte sur chaque jauge 17, 17', qui est soit une contrainte en compression pour la jauge vers laquelle le déplacement est orienté, soit une contrainte en traction pour l'autre jauge. Ainsi, une jauge fonctionne en compression tandis que l'autre jauge fonctionne en traction.

Comme illustré, la première extrémité 141 du bras de levier 4 présente de préférence une forme spécifique. Les deux jauges sont ainsi placées directement sous l'axe de rotation R afin d'être sollicitées au maximum en compression et/ou en traction. Cela a pour avantage de d'avoir un mouvement de compression/ traction de la jauge le plus pur possible (sans flexion parasite).

Une seconde configuration pour les jauges et les lames permet de mettre les jauges face à face comme illustré en figure 8B.

Dans cette seconde configuration, les deux jauges 17, 17' sont parallèles entre elles et reliées chacune à un ancrage 197, 197' et au bras de levier 14 (la masse n'est représentée sur la figure). Les lames 151 et 152 sont toujours orientées selon le même axe X.

Cela permet de conserver un design symétrique pour obtenir une lecture différentielle la meilleure possible.

Le bras de levier 14 comprend une seconde extrémité 142 reliée à la masse 13, via une seconde liaison 16. Cette seconde liaison peut également être nommée « liaison de couplage » ou « liaison de couplage et de découplage ». Elle doit transmettre le mouvement de la masse selon l'axe sensible S au bras de levier, et faire cohabiter la translation de la masse avec la rotation dudit bras autour de l'axe de rotation R.

Cette seconde liaison entre le bras de levier et la masse est disposée dans la partie centrale de la masse.

La seconde liaison peut comprendre une seule lame de couplage ou une lame de couplage principale et une ou plusieurs lames de couplage secondaires.

La figure 10A illustre une première variante de seconde liaison comprenant une lame de couplage.

La lame de couplage est utilisée en torsion et en flexion pour faire cohabiter le déplacement en arc de cercle du bout du bras de levier en rotation selon X, avec le déplacement en ligne droite de la masse en translation selon Z.

La lame de couplage 161 est une lame allongée selon l'axe X et comprenant une hauteur non négligeable selon l'axe Z (correspondant à l'épaisseur de la masse 13) de manière à être suffisamment rigide pour transmettre le mouvement de translation de la masse 13 au bras de levier 14 selon ledit axe. La lame de couplage 161 est fine selon l'axe Y de manière à autoriser la rotation du bras de levier 14 autour de l'axe de rotation R (parallèle à l'axe X) en Y.

Grâce à une telle lame de couplage, le déplacement de la masse 13 selon l'axe Y du plan n'est pas transmise au bras de levier, puisqu'au contraire la lame se tord dans cet axe du fait de sa finesse (on dit qu'elle est découplée). Ceci confère un avantage en cas de choc selon l'axe Y, lequel choc n'est pas transféré au bras de levier. Ainsi, cela ne vient pas parasiter le mouvement transmis et mesuré par la (ou les) jauge(s). Ainsi, lors de chocs, la jauge est préservée, et en fonctionnement normal, il y a moins de sensibilité transverse.

Par contre, la forte raideur de compression de la lame de couplage 161 selon l'axe X transmet les chocs selon l'axe X au bras de levier.

La lame de couplage peut être doublée, afin d'améliorer la linéarité du dispositif.

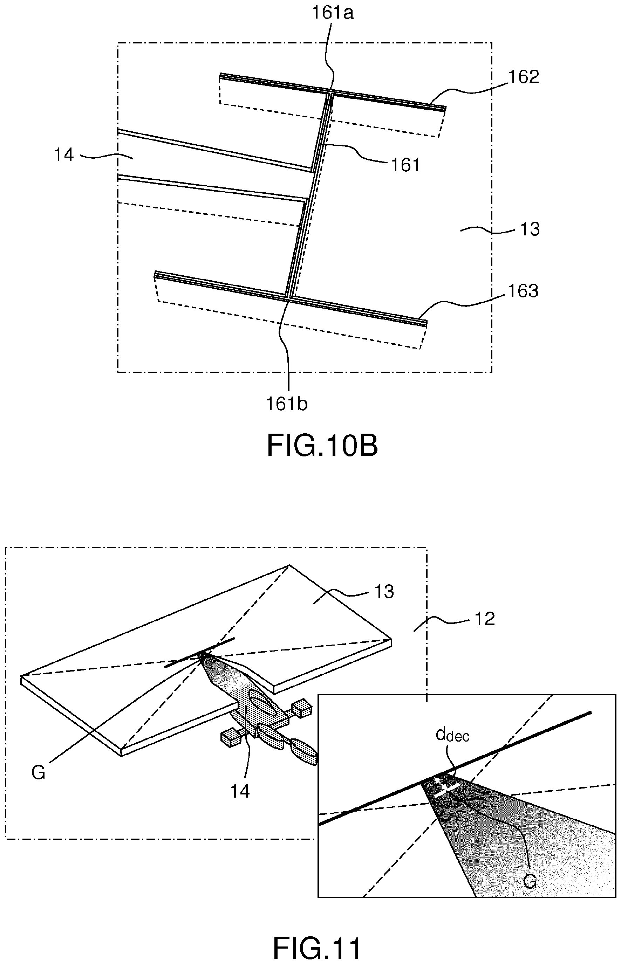

La figure 10B illustre une seconde variante de seconde liaison comprenant plusieurs lames de couplage. Cette seconde variante de seconde liaison se distingue de la première variante en ce qu'elle comprend en outre deux lames de couplage secondaires 162, 163, disposées perpendiculairement à la lame de couplage principale 161, et fixées respectivement à une première extrémité 161a et à une seconde extrémité 161b de ladite lame de couplage principale. Les épaisseurs des trois lames de couplage sont identiques. Les lames de couplage secondaires 162 et 163 sont allongées selon l'axe Y et fines selon l'axe X, alors que la lame de couplage principale 161 est allongée selon l'axe X et fine selon l'axe Y. Les lames de couplage secondaires permettent de découpler le mouvement entre la masse 13 et le bras de levier 14 dans l'autre axe Y du plan.

Ainsi, cette seconde variante de seconde liaison a pour avantage de ne permettre le couplage entre la masse 13 et le bras de levier 14 que selon l'axe sensible S. Il subsiste en général également la rotation hors plan, difficilement évitable.

L'accéléromètre selon l'invention permet de dissocier le mouvement de translation de la masse et le mouvement de rotation du bras de levier.

La masse se déplaçant en translation, son effet sur le moment d'inertie vu du bras de levier est réduit puisqu'il se rapproche de celui d'une masse ponctuelle. Cela permet ainsi un meilleur compromis entre la taille de la masse (et donc poids de la masse), la sensibilité de l'accéléromètre et la fréquence de résonance, et notamment pour un accéléromètre de masse donnée, un meilleur produit fréquence de résonance x sensibilité.

En outre, la liaison entre le bras de levier et la masse étant disposée dans la partie centrale de la masse, cela évite le risque de symétrie imparfaite, et par conséquent cela évite que la masse tourne en même temps que le bras de levier. Si la masse tournait en même temps, le moment d'inertie de la masse augmenterait à nouveau et la fréquence de résonance est diminuée, ce que l'invention permet d'éviter.

En outre, cela permet d'avoir deux jauges pour un bras de levier, les deux jauges étant proches entre elles, améliorant ainsi la précision de mesure, notamment lors d'une mesure différentielle.

Un seul bras de levier permet d'éviter des différences de bras de levier. Avec un seul bras de levier, les différences ne sont pas répercutées sur les jauges.

En outre, l'invention permet de gérer un déplacement selon le plan du substrat, ou un déplacement hors plan.

Selon l'invention, le bras de levier est gravé au cœur de la masse. Le centre de gravité de la masse ou barycentre de la masse ne se trouve donc pas à l'intersection des diagonales du rectangle formant la masse lorsque la masse est un rectangle, ou plus généralement au centre géométrique du plan de la masse.

Nous avons vu que le couplage de la masse au bras de levier est assuré par une seconde liaison élastique en torsion et/ou en flexion.

La raideur de la seconde liaison est largement inférieure à la raideur du bras de levier.

Cependant, il subsiste tout de même une raideur, laquelle entraine un couple qui fait tourner la masse. Ainsi, le couplage entre la rotation du bras de levier et celle de la masse, même faible, peut induire une rotation non souhaitée de la masse, s'il n'est pas contrebalancé.

La figure 11 illustre un mode de réalisation particulier de l'invention, qui permet d'améliorer davantage l'accéléromètre en évitant une rotation non souhaitée de la masse. Ce mode peut s'appliquer au premier mode (mode plan) et au second mode (mode hors plan).

Selon ce mode de réalisation, la liaison entre le bras de levier et la masse est légèrement décalée par rapport au centre de gravité de la masse, de sorte à induire un contre-couple. Un décalage astucieusement choisi permet d'annuler le couple de la seconde liaison qui peut faire tourner la masse.

A titre d'exemple, on choisit un décalage dans la direction longitudinale du bras de levier, et dans le sens opposé audit bras.

De manière à calculer la valeur de ce décalage $d_{dec}$ on peut se baser sur les calculs ci-après.

Le moment engendré $M_{cplg}$ par les liaisons de couplage (secondes liaisons) est le produit de l'angle $\alpha_{bras}$ du bras de levier avec la raideur angulaire $C_{cplg}$ des liaisons de couplage :

$$M_{cplg} = C_{cplg}\alpha_{bras}$$

L'angle $\alpha_{bras}$ du bras de levier peut s'exprimer à partir de sa longueur $D_{bras}$ et du déplacement de la masse $\Delta L_{masse}$ au niveau de la seconde liaison (le déplacement sera le même partout si on arrive effectivement à une translation de la masse). Le déplacement étant très petit devant la longueur, la tangente et l'angle sont confondus, ainsi :

$$\alpha_{bras} = \frac{\Delta L_{masse}}{D_{bras}}$$

Le décalage entre le centre de gravité de la masse et le point de liaison entre la liaison de couplage et ladite masse induit un moment, produit de la force, elle-même produit du poids m de la masse et de l'accélération $\gamma$, et de ce décalage :

$$M_{dec} = d_{dec}m\gamma$$

Pour que les deux couples s'annulent, il faut donc choisir ce décalage judicieusement de manière à ce que $M_{cplg} = M_{dec}$ ; soit :

$$d_{dec} = C_{cplg}\frac{\Delta L_{masse}}{D_{bras}}\frac{1}{m\gamma}$$

Enfin, le déplacement de la masse (apparentée à un ressort avec son levier et l'accélération sont reliés par la fréquence de résonance $\omega_0$ :

$$\Delta L_{masse} = \frac{Force}{Raideur} = \frac{m\gamma}{K} = \frac{m\gamma}{m\omega_0^2} = \frac{\gamma}{\omega_0^2}$$

En conclusion, on obtient la valeur de décalage:

$$d_{dec} = C_{cplg}\frac{1}{D_{bras}}\frac{1}{m\omega_0^2}$$

Une première zone/couche mince, présentant une première épaisseur peut former au moins la (ou les) jauge(s) piézoélectrique(s).

Par « mince », il faut comprendre de l'ordre de la centaine de nanomètre (nm), et inférieur à 1 micromètre ($\mu$m).

Les troisièmes liaisons (optionnelles) peuvent être réalisées en couche mince.

La seconde liaison peut, dans certaines variantes, être réalisée en couche mince (fil de couplage).

Une deuxième zone/couche épaisse, présentant une deuxième épaisseur supérieure à la première épaisseur, peut former au moins la masse sismique.

Par « épais », il faut comprendre entre 1 $\mu$m et 100 $\mu$m. De préférence, la couche épaisse est entre 1 et 20 $\mu$m, voire entre 1 et 10 $\mu$m.

La zone/couche épaisse peut former une seconde liaison dans certaines variantes (lame de couplage), et/ou la première liaison (liaison pivot).

Les jauges de contrainte peuvent être des jauges piézoélectriques ou piézorésistives, des poutres résonantes.

Les différents modes présentés peuvent être combinés entre eux.

La structure de l'accéléromètre peut être fabriquée en utilisant les technologies de micro-usinage (et/ou nano-usinage) d'accéléromètres connues, sur du silicium.

Ainsi, on peut mettre en œuvre le procédé général suivant :

- on part d'un silicium sur isolant (SOI) comprenant au moins une couche de substrat en Si, une couche sacrificielle de $SiO_2$ et une couche mince de Si ;
- on dépose une couche de Si plus épaisse, par épitaxie de Si ou par report d'une couche plus épaisse au-dessus de la couche mince en Si du SOI ;
- on définit sur le SOI et/ou sur la couche épaisse des motifs, par exemple par photolithographie ;
- on grave des couches de Si ou de $SiO_2$ afin de finaliser les motifs souhaités, de manière à former le bras de levier, la masse, les liaisons, le plot et la ou les jauges ;
- on peut déposer et graver une couche métallique, par exemple une superposition de chrome et d'or, pour définir les connexions électriques ; et
- on libère les parties mobiles par enlèvement (par exemple par gravure à l'acide ou à la vapeur) du $SiO_2$ sur lequel reposent ces parties mobiles (les parties mobiles peuvent être à cet effet percées de multiples petits trous par lesquels peuvent s'évacuer l'oxyde, laissant les parties mobiles en surplomb au-dessus du substrat).

A titre d'exemple, on peut mettre en œuvre le procédé suivant.

On part d'un substrat SOI (« Silicium On Insulator ») comportant par exemple une première couche de silicium (Si) formant le substrat, une première couche d'oxyde de silicium ($SiO_2$ ou « Buried Oxide »), par exemple d'épaisseur de 1 $\mu$m, et une seconde couche de Si sur la première couche de $SiO_2$. La première couche de $SiO_2$ forme la couche sacrificielle.

De préférence, la seconde couche de Si est en silicium monocristallin. Elle présente par exemple une épaisseur de 0,3 μm ou de 0,15 μm. Cette seconde couche de Si forme avantageusement la couche mince.

Il est ensuite procédé à une photolithographie, puis à une gravure de la seconde couche de Si pour définir au moins une jauge et définir le plot d'ancrage de ladite jauge avec le substrat. La gravure est arrêtée sur la première couche de $SiO_2$.

On procède ensuite au dépôt d'une seconde couche de $SiO_2$ destinée à former une couche d'arrêt. Ensuite, est réalisée une photolithographie destinée à délimiter une portion de la seconde couche de $SiO_2$ qui recouvre une jauge (ou plusieurs portions s'il y a plusieurs jauges). Une gravure de la seconde couche de $SiO_2$ est ensuite réalisée, supprimant celle-ci sauf au niveau de chaque portion.

La première couche de $SiO_2$ est également gravée pour pouvoir réaliser des plots d'ancrage avec le substrat (avec l'étape suivante).

Lors d'une étape suivante, on effectue un dépôt d'une troisième couche de Si par croissance épitaxiale sur la seconde couche de Si et sur chaque portion de la seconde couche de $SiO_2$ qui recouvre chaque jauge.

Cette troisième couche de Si forme avantageusement la couche épaisse. Cette couche a par exemple une épaisseur de 20 μm ou de 15 μm. Elle comporte par exemple une partie formée de silicium monocristallin et une partie formée de silicium polycristallin au-dessus de chaque portion de la seconde couche de $SiO_2$.

Lors d'une étape suivante, on effectue une photolithographie de la troisième couche de Si pour définir l'emplacement de plots d'ancrage.

Lors d'une étape suivante, on peut effectuer un dépôt d'une couche métallique dans laquelle seront réalisés les contacts électriques, puis une photolithographie peut être réalisée sur cette couche métallique pour protéger la couche métallique et la positionner juste au-dessus des plots d'ancrage, et enfin la couche métallique est gravée laissant seulement les contacts métalliques sur les plots d'ancrage.

Lors d'une étape suivante, on effectue une photolithographie destinée à permettre une gravure sélective de la troisième couche de Si, notamment pour supprimer la portion de silicium polycristallin située au-dessus de la jauge piézorésistive et pour définir le bras de levier, la masse, les liaisons et les plots d'ancrage avec la première couche de Si (ou substrat). On effectue ensuite des gravures verticales dans l'épaisseur de la troisième couche de Si jusqu'à la première couche de $SiO_2$ ou la portion de la seconde couche de $SiO_2$ qui recouvre la jauge. La gravure peut être réalisée par DRIE (Deep Reactive Ion Etching).

Lors d'une étape suivante, on libère le bras de levier, la masse et les liaisons, en retirant la première couche de $SiO_2$, et on libère chaque jauge en retirant la portion de la seconde couche de $SiO_2$, par exemple au moyen d'acide fluoridrique liquide et/ou vapeur.

Il peut s'agir d'une gravure au temps, l'acide fluoridrique est alors laissé au contact de la première couche de $SiO_2$ le temps nécessaire pour libérer certaines parties mobiles mais laisser ladite couche de $SiO_2$ sous des parties fixes.

Dans cet exemple, toutes les liaisons sont réalisées sur couche épaisse. Un procédé du même type peut être adapté pour réaliser certaines liaisons dans la couche mince et d'autres dans la couche épaisse.

Le procédé peut être adapté pour réaliser les différentes variantes de l'accéléromètre.

En outre, la présente invention n'est pas limitée aux modes de réalisation précédemment décrits mais s'étend à tout mode de réalisation entrant dans la portée des revendications.

**Revendications**

1. Accéléromètre MEMS ou NEMS (1, 11) apte à mesurer une accélération selon un axe sensible (S) comprenant :

   - un substrat (2, 12) présentant un plan (XY) ;
   - une masse (3, 13) présentant une zone centrale et suspendue par rapport au substrat (2, 12) ;
   - un unique bras de levier (4, 14) formant structure d'amplification d'effort de la masse, comprenant :

      • une première extrémité (41, 141) reliée au substrat (2, 12) par l'intermédiaire d'une première liaison (5, 15) apte à autoriser la rotation du bras de levier autour d'un axe de rotation (R) perpendiculaire à l'axe sensible (S), et
      • une seconde extrémité (42, 142) reliée à la masse (3, 13) par l'intermédiaire d'une seconde liaison (6, 16) apte à transmettre le mouvement de translation de la masse (3, 13) au bras de levier (4, 14) tout en autorisant la rotation dudit bras de levier autour de l'axe de rotation (R) ;

   la seconde extrémité (42, 142) du bras de levier (4, 14) étant disposée au niveau de la zone centrale de la masse (3, 13) ;
   - au moins une jauge de contrainte (7, 7', 17, 17'), ladite jauge étant reliée au bras de levier (4), chaque jauge comprenant :

      • une première extrémité (71, 71', 171, 171') reliée au substrat (2, 12), et
      • une seconde extrémité (72, 72', 172, 172') reliée au bras de levier (4, 14),

   la seconde liaison (6, 16) comprenant une lame de couplage principale (61, 161) rigide selon l'axe sensible (S) et souple selon l'axe de rotation (R) du bras de levier (4, 14).

2. Accéléromètre (1) selon la revendication 1, comprenant au moins deux jauges de contrainte (7, 7', 17, 17').

3. Accéléromètre (1) selon la revendication 2, deux jauges de contrainte étant disposées de part et d'autre de la première extrémité (41, 141) du bras de levier (4, 14).

4. Accéléromètre (1, 11) selon l'une des revendications 1 à 3, la masse (3, 13) étant suspendue par rapport au substrat (2, 12) par au moins une troisième liaison (8, 18, 4, 14) apte à autoriser la translation de ladite masse selon l'axe sensible (S).

5. Accéléromètre (1, 11) selon la revendication 4, au moins une troisième liaison (8, 18) comprenant une lame souple (81, 81', 181) selon l'axe sensible (S).

6. Accéléromètre (1, 11) selon l'une des revendications 4 ou 5, comprenant plusieurs troisièmes liaisons (8, 18) réparties de manière équilibrée par rapport au centre de gravité (G) de la masse (3, 13).

7. Accéléromètre (1, 11) selon l'une des revendications 1 à 3, la masse (3, 13) étant suspendue par rapport au substrat (2, 12) uniquement par le bras de levier (4, 14).

8. Accéléromètre (1, 11) selon l'une des revendications 1 à 7, la seconde extrémité (42, 142) du bras de levier (4, 14) étant disposée au niveau du centre de gravité (G) de la masse (3, 13).

9. Accéléromètre (1, 11) selon l'une des revendications 1 à 7, la seconde extrémité (42, 142) du bras de levier (4, 14) étant décalée ($d_{dec}$) par rapport au centre de gravité (G) de la masse (3, 13).

10. Accéléromètre (1) selon l'une des revendications 1 à 9, l'axe sensible (S) étant dans le plan (XY) du substrat (2).

11. Accéléromètre (1) selon la revendication 10, la première extrémité (41) du bras de levier (4) présentant une forme amincie selon l'axe sensible (S).

12. Accéléromètre (1) selon l'une des revendications 10 ou 11, la première liaison (5) comprenant deux lames (51, 52) non parallèles, formant une charnière (53) apte à permettre la rotation du bras de levier (4) autour de l'axe de rotation (R) perpendiculaire à l'axe sensible (S).

13. Accéléromètre (1) selon la revendication 12, les deux lames (51, 52) étant perpendiculaires entre elles.

14. Accéléromètre (11) selon l'une des revendications 1 à 9, l'axe sensible (S) étant perpendiculaire au plan (XY) du substrat (12).

15. Accéléromètre (11) selon la revendication 14, la première liaison (15) comprenant deux lames (151, 152) colinéaires, configurées de manière à former l'axe de rotation (R) du bras de levier (14).

16. Accéléromètre (11) selon la revendication 15, la seconde liaison (16) comprenant en outre au moins une lame de couplage secondaire (162, 163) reliée à la lame de couplage principale (161) et perpendiculaire à ladite lame de couplage principale.

**Patentansprüche**

1. MEMS- oder NEMS-Beschleunigungsmesser (1, 11), welcher in der Lage ist, eine Beschleunigung entlang einer empfindlichen Achse (S) zu messen, Folgendes umfassend:

- ein Substrat (2, 12), welches eine Ebene (XY) aufweist;
- eine Masse (3, 13), welche einen mittleren Bereich aufweist und in Bezug auf das Substrat (2, 12) aufgehängt ist;
- einen einzigen Hebelarm (4, 14), welcher eine Verstärkungsstruktur der Massenkraft bildet, Folgendes umfassend:

• ein erstes mit dem Substrat (2, 12) über eine erste Verbindung (5, 15) verbundenes Ende (41, 141), welches in der Lage ist, die Drehung des Hebelarms um eine Drehachse (R) zu erlauben, welche rechtwinklig zur empfindlichen Achse (S) ist, und
• ein zweites mit der Masse (3, 13) über eine zweite Verbindung (6, 16) verbundenes Ende (42, 142), welches in der Lage ist, die Verschiebungsbewegung der Masse (3, 13) an den Hebelarm (4, 14) zu übertragen und gleichzeitig die Drehung des Hebelarms um die Drehachse (R) zu erlauben;

wobei das zweite Ende (42, 142) des Hebelarms (4, 14) auf Höhe des mittleren Bereichs der Masse (3, 13) angeordnet ist;
- mindestens ein Spannungsmessgerät (7, 7', 17, 17'), wobei das Messgerät mit dem Hebelarm (4) verbunden ist, wobei jedes Messgerät Folgendes umfasst:

• ein erstes mit dem Substrat (2, 12) verbundenes Ende (71, 71', 171, 171'), und
• ein zweites mit dem Hebelarm (4, 14) verbundenes Ende (72, 72', 172, 172'),

wobei die zweite Verbindung (6, 16) ein entlang der empfindlichen Achse (S) starres und entlang der Drehachse (R) des Hebelarms (4, 14) flexibles Hauptkopplungsblatt (61, 161) umfasst.

2. Beschleunigungsmesser (1) nach Anspruch 1, welcher mindestens zwei Spannungsmessgeräte (7, 7', 17, 17') umfasst.

3. Beschleunigungsmesser (1) nach Anspruch 2, wobei zwei Spannungsmessgeräte beiderseits des ersten Endes (41, 141) des Hebelarms (4, 14) angeordnet sind.

4. Beschleunigungsmesser (1, 11) nach einem der Ansprüche 1 bis 3, wobei die Masse (3, 13) in Bezug auf das Substrat (2, 12) durch mindestens eine dritte Verbindung (8, 18, 4, 14) aufgehängt ist, welche in der Lage ist, die Verschiebung der Masse entlang der empfindlichen Achse (S) zu erlauben.

5. Beschleunigungsmesser (1, 11) nach Anspruch 4, wobei mindestens eine dritte Verbindung (8, 18) ein entlang der empfindlichen Achse (S) flexibles Blatt (81, 81', 181) umfasst.

6. Beschleunigungsmesser (1, 11) nach einem der Ansprüche 4 oder 5, welcher mehrere dritte Verbindungen (8, 18) umfasst, welche ausgewogen in Bezug auf den Gewichtsmittelpunkt (G) der Masse (3, 13) verteilt sind.

7. Beschleunigungsmesser (1, 11) nach einem der Ansprüche 1 bis 3, wobei die Masse (3, 13) in Bezug auf das Substrat (2, 12) nur durch den Hebelarm (4, 14) aufgehängt ist.

8. Beschleunigungsmesser (1, 11) nach einem der Ansprüche 1 bis 7, wobei das zweite Ende (42, 142) des Hebelarms (4, 14) auf Höhe des Gewichtsmittelpunkts (G) der Masse (3, 13) angeordnet ist.

9. Beschleunigungsmesser (1, 11) nach einem der Ansprüche 1 bis 7, wobei das zweite Ende (42, 142) des Hebelarms (4, 14) in Bezug auf den Gewichtsmittelpunkt (G) der Masse (3, 13) versetzt ($d_{dec}$) ist.

10. Beschleunigungsmesser (1) nach einem der Ansprüche 1 bis 9, wobei die empfindliche Achse (S) in der Ebene (XY) des Substrats (2) liegt.

11. Beschleunigungsmesser (1) nach Anspruch 10, wobei das erste Ende (41) des Hebelarms (4) eine entlang der empfindlichen Achse (S) verschmälerte Form aufweist.

12. Beschleunigungsmesser (1) nach einem der Ansprüche 10 oder 11, wobei die erste Verbindung (5) zwei nicht parallele Blätter (51, 52) umfasst, welche ein Scharnier (53) bilden, welches in der Lage ist, die Drehung des Hebelarms (4) um die Drehachse (R) zu erlauben, welche rechtwinklig zur empfindlichen Achse (S) ist.

13. Beschleunigungsmesser (1) nach Anspruch 12, wobei die beiden Blätter (51, 52) rechtwinklig zueinander sind.

14. Beschleunigungsmesser (11) nach einem der Ansprüche 1 bis 9, wobei die empfindliche Achse (S) rechtwinklig zur Ebene (XY) des Substrats (12) ist.

15. Beschleunigungsmesser (11) nach Anspruch 14, wobei die erste Verbindung (15) zwei kolineare Blätter (151, 152) umfasst, welche konfiguriert sind, um die Drehachse (R) des Hebelarms (14) zu bilden.

16. Beschleunigungsmesser (11) nach Anspruch 15, wobei die zweite Verbindung (16) ferner mindestens ein sekundäres Kopplungsblatt (162, 163) umfasst, welches mit dem Hauptkopplungsblatt (161) verbunden und rechtwinklig zu dem Hauptkopplungsblatt ist.

## Claims

1. MEMS or NEMS accelerometer (1, 11) adapted to measure an acceleration along a sensing axis (S) comprising:

  - a substrate (2, 12) featuring a plane (XY);
  - a mass (3, 13) having a central zone and suspended relative to the substrate (2, 12);
  - a single lever arm (4, 14) forming a mass force amplification structure, comprising:

    • a first end (41, 141) connected to the substrate (2, 12) by means of a first connection (5, 15) adapted to allow rotation of the lever arm about a rotation axis (R) perpendicular to the sensing axis (S), and
    • a second end (42, 142) connected to the mass (3, 13) by means of a second connection (6, 16) adapted to transmit the translation movement of the mass (3, 13) to the lever arm (4, 14) whilst allowing rotation of said lever arm about the rotation axis (R);

    the second end (42, 142) of the lever arm (4, 14) being disposed at the level of the central zone of the mass (3, 13);

- at least one strain gauge (7, 7', 17, 17'), said gauge being connected to the lever arm (4), each gauge comprising:

• a first end (71, 71', 171, 171') connected to the substrate (2, 12), and
• a second end (72, 72', 172, 172') connected to the lever arm (4, 14),

the second connection (6, 16) comprising a main coupling blade (61, 161) rigid along the sensing axis (S) and flexible along the rotation axis (R) of the lever arm (4, 14).

2. Accelerometer (1) according to Claim 1, comprising at least two strain gauges (7, 7', 17, 17').

3. Accelerometer (1) according to Claim 2, two strain gauges being disposed on either sides of the first end (41, 141) of the lever arm (4, 14).

4. Accelerometer (1, 11) according to any one of Claims 1 to 3, the mass (3, 13) being suspended relative to the substrate (2, 12) by at least one third connection (8, 18, 4, 14) adapted to allow the translation of said mass along the sensing axis (S).

5. Accelerometer (1, 11) according to Claim 4, at least one third connection (8, 18) comprising a flexible blade (81, 81', 181) along the sensing axis (S).

6. Accelerometer (1, 11) according to either one of Claims 4 or 5, comprising multiple third connections (8, 18) distributed in a balanced manner relative to the centre of gravity (G) of the mass (3, 13).

7. Accelerometer (1, 11) according to any one of Claims 1 to 3, the mass (3, 13) being suspended relative to the substrate (2, 12) only by the lever arm (4, 14).

8. Accelerometer (1, 11) according to any one of Claims 1 to 7, the second end (42, 142) of the lever arm (4, 14) being disposed at the level of the centre of gravity (G) of the mass (3, 13).

9. Accelerometer (1, 11) according to any one of Claims 1 to 7, the second end (42, 142) of the lever arm (4, 14) being offset ($d_{dec}$) relative to the centre of gravity (G) of the mass (3, 13).

10. Accelerometer (1) according to any one of Claims 1 to 9, the sensing axis (S) being in the plane (XY) of the substrate (2).

11. Accelerometer (1) according to Claim 10, the first end (41) of the lever arm (4) having a tapered shape along the sensing axis (S).

12. Accelerometer (1) according to either one of Claims 10 or 11, the first connection (5) comprising two non-parallel blades (51, 52) forming a hinge (53) adapted to allow the rotation of the lever arm (4) about the rotation axis (R) perpendicular to the sensing axis (S).

13. Accelerometer (1) according to Claim 12, the two blades (51, 52) being mutually perpendicular.

14. Accelerometer (11) according to any one of Claims 1 to 9, the sensing axis (S) being perpendicular to the plane (XY) of the substrate (12).

15. Accelerometer (11) according to Claim 14, the first connection (15) comprising two colinear blades (151, 152) configured to form the rotation axis (R) of the lever arm (14).

16. Accelerometer (11) according to Claim 15, the second connection (16) further comprising at least one secondary coupling blade (162, 163) connected to the main coupling blade (161) and perpendicular to said main coupling blade.

FIG.1 (ART ANTERIEUR)

FIG.2 (ART ANTERIEUR)

FIG.3

FIG.4A

FIG.4B

FIG.5A

FIG.5B

FIG.6A

FIG.6B

FIG.7

FIG.8A

FIG.8B

FIG.9

FIG.10A

FIG.10B

FIG.11

## RÉFÉRENCES CITÉES DANS LA DESCRIPTION

### Documents brevets cités dans la description

- EP 2211185 A
- FR 2951826
- FR 2906038